# EUROPÄISCHE PATENTSCHRIFT

(11) **EP 1 305 857 B1**
(45) Veröffentlichungstag und Bekanntmachung des Hinweises auf die Patenterteilung: **28.07.2010**
(21) Anmeldenummer: 01966992.8
(22) Anmeldetag: 31.07.2001
(51) Int. Cl.: H01S 5/183

(54) **OBERFLÄCHENEMITTIERENDER LASER MIT SEITLICHER STROMINJEKTION**
SURFACE-EMITTING LASER HAVING LATERAL CURRENT INJECTION
LASER A EMISSION PAR LA SURFACE, A INJECTION DE COURANT LATERALE

(30) Priorität: 04.08.2000 DE 10038235
(43) Veröffentlichungstag der Anmeldung: 02.05.2003
(73) Patentinhaber: OSRAM Opto Semiconductors GmbH, 93055 Regensburg (DE)
(72) Erfinder: ALBRECHT, Tony, 93077 Bad Abbach (DE)
(74) Vertreter: Epping - Hermann - Fischer
(86) Internationale Anmeldenummer: PCT/DE2001/002903
(87) Internationale Veröffentlichungsnummer: WO 2002/013334

(56) Entgegenhaltungen:
- US-A- 5 343 487
- US-A- 5 936 266
- US-A- 6 044 100
- WIPIEJEWSKI T ET AL: "PERFORMANCE AND RELIABILITY OF OXIDE CONFINED VCSELS" 1999 PROCEEDINGS 49TH. ELECTRONIC COMPONENTS AND TECHNOLOGY CONFERENCE. ECTC 1999. SAN DIEGO, CA, JUNE 1 - 4, 1999, PROCEEDINGS OF THE ELECTRONIC COMPONENTS AND TECHNOLOGY CONFERENCE, NEW YORK, NY: IEEE, US, Juni 1999 (1999-06), Seiten 741-746, XP000912001 ISBN: 0-7803-5232-7

## Beschreibung

Oberflächenemittierende Laser mit senkrecht stehendem Resonator (Vertical Cavity Surface Emitting Laser, VCSEL) sind beispielsweise aus IEEE Communications Magazine, May 97, pp. 164-170 bekannt. Diese Laser beinhalten einen Halbleiterkörper und weisen das gemeinsame strukturelle Merkmal auf, daß die Resonatorachse und damit auch die Lichtemission senkrecht zu einer Hauptfläche des Halbleiterkörpers erfolgt.

Der Pumpstrom wird üblicherweise über Kontaktflächen in den Halbleiterkörper eingeleitet. Bekannt ist hierbei die Möglichkeit, eine Kontaktfläche in Form eines Ringkontakts auf einer Hauptfläche des Halbleiterkörpers anzuordnen, wobei durch dieselbe Hauptfläche die Laserstrahlung ausgekoppelt wird.

Von dem Ringkontakt aus wird der Pumpstrom auf direktem Weg zu der aktiven Schicht des Halbleiterkörpers geleitet. Um eine hohe Pumpdichte zu erzielen beziehungsweise den Schwellenstrom gering zu halten, wird der Pumpstrom mit Hilfe einer blendenartigen Stromeinschnürungsschicht auf ein kleines Volumen der aktiven Schicht, im folgenden als "aktives Volumen" bezeichnet, konzentriert. Die Generation und die Verstärkung der Laserstrahlung findet in diesem aktiven Volumen statt. Die Laserstrahlung wird innerhalb der Ringöffnung der Kontaktfläche ausgekoppelt.

Bei dieser Geometrie sind der Pfad des Pumpstroms durch den Halbleiterkörper (Stromweg) und das erzeugte Strahlungsfeld im Halbleiterkörper (Lichtweg) zu großen Teilen deckungsgleich. Dadurch wird das Strahlungsfeld und insbesondere dessen räumliche Feldverteilung durch den Pumpstrom beeinflußt, da in Abhängigkeit des Pumpstroms die elektrische Verlustwärme und damit die Temperatur des Halbleiterkörpers variiert. Mit steigendem Pumpstrom bildet sich im Resonator ein radialsymmetrisches Temperaturprofil aus. Aufgrund der Abhängigkeit des Brechungsindex des Halbleiterkörpers von der Temperatur entsteht eine thermische Indexführung, die auch als positive thermische Linse bezeichnet wird.

Eine positive thermische Linse führt zu einer Einschnürung der Resonatorgrundmode, so daß der Überlapp zwischen Grundmode und aktivem Volumen und damit die Verstärkung der Grundmode reduziert wird. Räumliches Lochbrennen verringert die Verstärkung der Grundmode weiter bis zur Auslöschung der Grundmode. Dies begünstigt auch das Anschwingen unerwünschter höherer Moden, so daß ein Grundmodenbetrieb (SM-Betrieb, single mode) bei hohem Pumpstrom nicht möglich ist.

Dieser Nachteil wird gemindert, wenn Licht- und Stromweg getrennt werden. VCSEL mit einer teilweisen Trennung von Licht- und Stromweg sind beispielsweise aus US 6,044,100 bekannt. Die hierin beschriebene, sogenannte laterale Injektion erfordert einen hohen Herstellungsaufwand, da für ihre Ausbildung eine aufwendige Mesa-Ätzung des Halbleiterkörpers unter Verwendung einer Ätzstopschicht nötig ist.

Weiterhin ist bei dem in US 6,044,100 beschriebenen VCSEL die Größe des aktiven Volumens fest vorgegeben und im wesentlichen durch den Innendurchmesser der Stromeinschnürungsschicht bestimmt, so daß der VCSEL nur für einen Arbeitspunkt optimiert ist.

Aufgabe der vorliegenden Erfindung ist es daher, einen VCSEL mit verbesserter Stromführung zu schaffen, der gleichzeitig kostengünstig herstellbar ist. Diese Aufgabe wird durch einen VCSEL gemäß Patentanspruch 1 gelöst. Vorteilhafte Weiterbildungen sind Gegenstand der anhängigen Ansprüche. Erfindungsgemäß ist vorgesehen, den VCSEL an der Hauptfläche, an der die erzeugte Strahlung zumindest teilweise ausgekoppelt wird (Auskoppelfläche), zu kontaktieren, wobei der Pumpstrom von dieser Hauptfläche aus zur aktiven Schicht hin weitestgehend außerhalb des Resonatorvolumens geführt wird. Die Trennung zwischen Licht- und Stromweg ist dabei auf das Resonatorvolumen zwischen Auskoppelfläche und aktivem Volumen beschränkt, da das aktive Volumen naturgemäß innerhalb des Resonators liegt und der Pumpstrom in dieses aktive Volumen eingeleitet werden muß.

Um diese Trennung zu realisieren, wird in einem ersten Bereich, der an die Auskoppelfläche grenzt, der Pumpstrom parallel zur Resonatorachse außerhalb des Resonatorvolumens geführt. In einem zweiten Bereich in der Nähe der aktiven Schicht wird dann der Pumpstrom radial zum aktiven Volumen hingeleitet.

Da der Pumpstrom weitgehend von dem Resonatorvolumen ferngehalten wird, wird auch die durch die elektrische Verlustleistung verursachte Temperaturerhöhnung und speziell der daraus resultierende Temperaturgradient im Resonator reduziert. Im Resonatorvolumen wird so die Ausbildung einer positiven thermischen Linse vermieden. Dieses auf der verbesserten Stromführung basierende, gleichmäßigere Temperaturverhalten verhindert mit großem Vorteil ein Einschnüren der Grundmode und das unerwünschte Anschwingen höherer Moden bei steigendem Pumpstrom.

Hinzu kommt, daß aufgrund elektrischer Verluste eine Temperaturerhöhung des Halbleiterkörpers außerhalb des Resonatorvolumens eintritt. Dies führt umgekehrt zu einer negativen thermischen Linse im Resonator, die ebenfalls einer Einschnürung der Grundmode entgegenwirkt. Mit großem Vorteil ermöglicht die Erfindung so VCSEL mit hoher Effizienz, hoher Steilheit (slope efficiency) und hoher Quantenausbeute, die über einen weiten Pumpstrombereich im Grundmodus betrieben werden können.

Bei der Erfindung wird die Führung des Pumpstroms außerhalb des Resonators dadurch erreicht, daß zwischen dem stromführenden ersten Bereich außerhalb des Resonators und dem Resonator eine elektrische Isolationsschicht ausgebildet ist. So wird mit Vorteil der bestehende Halbleiterkörper zur Stromführung benutzt. Ferner ist diese Isolationsstruktur vorteilhafterweise ohne großen Aufwand in bestehende VCSEL-Strukturen integrierbar.

Bei einer bevorzugten Weiterbildung der Erfindung wird die Isolationsschicht durch Ionenimplantation ausgebildet. Hierbei wird durch gezielte Ionenimplantation in dem zu isolierenden Bereich eine hohe Zahl von Gitterdefekten erzeugt, so daß der Halbleiter in diesem Bereich zum elektrischen Isolator degradiert. Mit Vorteil wird dieses oft angewendete und daher leicht verfügbare Verfahren zur Ausbildung der Isolationsschicht bei der Erfindung herangezogen.

Alternativ kann die Isolationsschicht durch einen Ätzgraben ausgebildet werden. Der Ätzgraben kann dabei frei bleiben oder mit einem Isolations- oder Absorbermaterial aufgefüllt werden. Absorbermaterialien weisen neben ihrer Isolationseigenschaft eine hohe Absorption im Spektralbereich der Laseremissionswellenlänge auf. Diese Absorption im Außenbereich des Resonators unterdrückt höhere Moden und unterstützt so den Grundmodenbetrieb.

Die Bildung von Isolationsschichten bei der Herstellung von Halbleiterkörpern ist bekannt und erprobt und erfordert daher mit Vorteil keinen besonderen Aufwand. Weiterhin kann eine so gebildete Halbleiterstruktur leichter mit gut leitenden ohmschen Kontakten versehen werden als beispielsweise eine Halbleiterstruktur mit Mesaätzung.

Eine bevorzugte Weiterbildung der Erfindung besteht darin, die Kontaktfläche auf der Auskopplungsfläche ringförmig auszubilden. Im Betrieb wird die erzeugte Laserstrahlung durch die Ringöffnung ausgekoppelt. Der so gebildete VCSEL weist eine hervorragende Strahlqualität auf, wobei der Ringkontakt mit Vorteil nur zu einer geringen Abschattung der Auskoppelfläche führt.

Bei einer besonders bevorzugten Weiterbildung der Erfindung ist die Kontaktfläche ringförmig ausgebildet, wobei die Kontaktfläche nicht geschlossen ist. Alternativ kann die Kontaktfläche U-förmig ausgebildet sein. Besonders bevorzugt ist eine V-förmige Ausbildung des Kontakts.

Diese Kontaktformen werden im folgenden im Gegensatz zu einem geschlossenen Ringkontakt als "offene Kontakte" bezeichnet. Offene Kontakte bewirken, daß die Größe des aktiven Volumens vom Pumpstrom abhängt und mit steigendem Pumpstrom wächst. Damit wird ein selbstregulierendes Verhalten des VCSEL erreicht mit dem großen Vorteil, daß der VCSEL nicht nur für einen Arbeitspunkt, sondern für einen Arbeitsbereich optimiert ist.

Vorteilhafte Kontaktformen für die Selbstregulierung sind Ringkontakte mit nicht geschlossenem Ring, U-förmige Kontakte und V-förmige Kontakte, wobei V-förmige Kontakte hinsichlich der selbstregulierenden Eigenschaften besonders vorteilhaft sind.

Bei dieser Weiterbildung der Erfindung ist mit Vorteil das aktive Volumen insbesondere auch für niedrige Pumpströme optimal angepaßt, so daß sich ein so gebildeter VCSEL durch einen sehr niedrigen Schwellenstrom und eine hohe Steilheit auszeichnet.

Eine weitere bevorzugte Ausgestaltung der Erfindung besteht darin, den lateralen Querschnitt der Isolationsschicht an die Form der Kontaktfläche auf der Auskoppelfläche anzupassen. Unter einem lateralen Querschnitt ist ein Querschnitt mit einer zur Resonatorachse orthogonalen Schnittebene zu verstehen. Diese Anpassung gewährleistet mit Vorteil, daß der Pumpstrom entlang der Kontaktform im zweiten Bereich gleichartig radial dem aktiven Volumen zugeführt wird und unterstützt so den Selbstregulierungsmechanismus.

Weitere Merkmale, Vorteile und Zweckmäßigkeiten der Erfindung ergeben sich aus der nachfolgenden Beschreibung von drei Ausführungsbeispielen in Verbindung mit den Figuren 1 bis 4. Es zeigen
Figur 1 eine schematische Schnittansicht eines ersten erfindungsgemäßen Ausführungsbeispiels,
Figur 2 eine schematische Aufsicht eines zweiten erfindungsgemäßen Ausführungsbeispiels,
Figur 3 eine schematische Aufsicht eines dritten erfindungsgemäßen Ausführungsbeispiels und
Figur 4 eine schematische Schnittansicht des dritten erfindungsgemäßen Ausführungsbeispiels.

Hierbei sind gleiche oder gleichwirkende Teile mit demselben Bezugszeichen versehen.

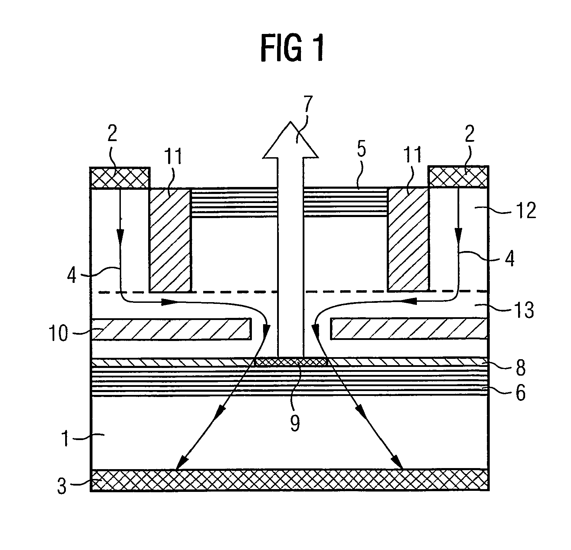

In Figur 1 ist eine Schnittansicht eines ersten Ausführungsbeispiels der Erfindung dargestellt, wobei die Resonatorachse in der Schnittebene liegt. Gezeigt ist der Halbleiterkörper 1 eines VCSEL mit einer ersten und einer zweiten Hauptfläche, auf denen jeweils eine Kontaktfläche 2 und 3 zur Zu- beziehungsweise Ableitung des Pumpstroms 4 gebildet ist. Der Resonator wird durch die Spiegel 5 und 6 begrenzt, wobei die erzeugte Laserstrahlung 7 über den Spiegel 5 und die erste Hauptfläche ausgekoppelt wird. Der auf dieser Hauptfläche aufgebrachte Kontakt 2 stellt einen Ringkontakt oder einen offenen Kontakt dar.

An den zweiten Resonatorspiegels 6 grenzt die aktive Schicht 8, in deren Zentrum sich im Betrieb das aktive Volumen 9 ausbildet. In Richtung der Auskoppelfläche ist über der aktiven Schicht eine Stromeinschnürungsschicht 10 in Form einer ringförmigen Isolationsschicht mit leitfähigem Zentrum gebildet, die den Pumpstrom 4 im Zentrum der aktiven Schicht 8 konzentriert.

Um das Resonatorvolumen herum ist eine Isolationsschicht 11 ausgebildet, die sich in Richtung der Resonatorachse von der Auskoppelfläche bis in die Nähe der Stromeinschnürungsschicht 10 erstreckt. Diese Isolationsschicht 11 bewirkt eine definierte Führung des Pumpstroms 4, so daß dieser in einem ersten Bereich 12 außerhalb des Resonators parallel zur Resonatorachse geführt wird.

Bei einem VCSEL nach dem Stand der Technik hingegen dringt der Pumpstrom auf direktem Weg zur Öffnung der Stromeinschnürungsschicht in das Resonatorvolumen ein und verursacht so die oben beschriebenen, nachteiligen thermischen Effekte im Resonator. In einem an die Stromeinschnürungsschicht 10 angrenzenden zweiten Bereich 13 wird der Strom dann durch den leitfähigen Spalt zwischen Isolationsschicht 11 und Stromeinschnürungsschicht 10 radial zur Öffnung der Stromeinschnürungsschicht 10 geführt.

Die Isolationsschicht 11 kann beispielsweise durch Ionenimplantation unter Verwendung einer geeigneten Maske hergestellt werden. Die Tiefe der Schicht (in Richtung der Resonatorachse) und damit die Größe des Spalts zwischen Isolationsschicht 11 und Stromeinschnürungsschicht 10 wird dabei durch die Ionenenergie bestimmt. Dasselbe Verfahren kann auch zur Ausbildung der Stromeinschnürungsschicht 10 verwendet werden.

Alternativ kann die Stromeinschnürungsschicht 10 auch durch eine entsprechend maskierte Oxidschicht ausgebildet werden.

Eine weitere Möglichkeit zur Ausbildung der Isolationsschicht 11 besteht darin, zwischen dem ersten Bereich 12 und dem Resonatorvolumen einen Graben zu ätzen. Die Grabentiefe wird durch die Ätzdauer festgelegt, so daß die aufwendige Ausbildung einer Ätzstopschicht nicht erforderlich ist. Optional kann danach der Graben mit einem Isolations- oder Absorbermaterial gefüllt werden.

Hinsichtlich der verwendbaren Materialien und des weiteren Aufbaus ist die Erfindung keinen prinzipiellen Beschränkungen unterworfen. Als Halbleiter können beispielsweise GaAs- oder InP-basierende Systeme, insbesondere InGaAlAs, InGaN, InGaAsP oder InGaAlP verwendet werden.

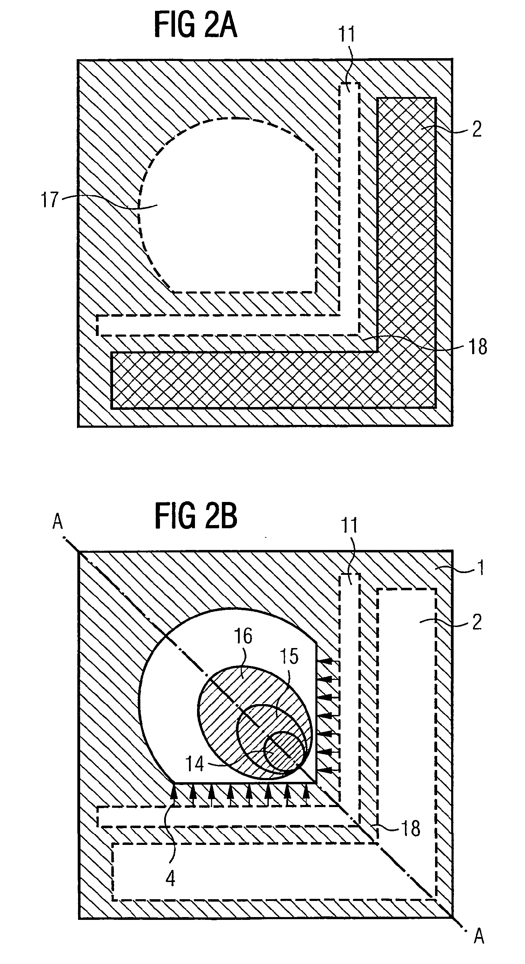

In Figur 2a ist die Aufsicht auf die auskoppelseitige Kontaktfläche 2 eines zweiten Ausführungsbeispiels der Erfindung gezeigt. Diese Kontaktfläche ist V-förmig mit einem rechten Winkel zwischen den beiden V-Schenkeln gestaltet. Die Isolationsschicht 11 ist in ihrem Querschnitt ebenfalls V-förmig gestaltet und entspricht so der Form der Kontaktfläche 2. Der Flächenausschnitt 17 stellt den leitfähigen Innenbereich der Stromeinschnürungsschicht 10 dar.

In Figur 2b ist schematisch die Wirkung der V-förmigen Kontaktfläche veranschaulicht. Bei kleinem Pumpstrom 4 wird nur in einem kleinen Bereich 14 eine Besetzungsinversion in der Nähe des V-Kontakt-Scheitels 18 erzeugt. Mit steigendem Pumpstrom wächst der besetzungsinvertierte Bereich an und das aktive Volumen wird vergrößert. Dies beruht auf der Überlagerung der von den beiden V-Schenkeln injizierten Anteile des Pumpstroms und wird ermöglicht durch die durch die Isolationsschicht 11 bewirkte, definiert radiale Stromzuführung zur Öffnung der Stromeinschnürungsschicht 10 hin.

Aus der Vergrößerung des aktiven Volumens mit steigendem Pumpstrom 4 resultiert ein selbstregulierendes Verhalten des VCSEL, das auf folgendem Zusammenhang beruht:
Für den stabilen Betrieb eines Lasers mit Fabry-Perot-Resonator, wie er auch in einem VCSEL verwendet wird, ist eine sogenannte Modenblende nötig, da ein Fabry-Perot-Resonator, insbesondere in der Form, in der er für VCSEL ausgebildet wird, nur eine sehr geringe transversale Modenselektivität besitzt. Ein Fabry-Perot-Resonator ist daher auch nur grenzwertig stabil. Die Modenblende legt die transversale Ausdehnung der Resonatormode fest.

In einem VCSEL wird eine Modenblende durch das aktive Volumen in Form einer aktiven Blende gebildet. Dieses aktive Volumen ist einerseits hinreichend klein zu wählen, um eine hohe Pumpdichte zu erzielen. Andererseits steigt mit zunehmender Verringerung des aktiven Volumens der Herstellungsaufwand stark an, während die optische Ausgangsleistung sinkt.

Eine Modenblende mit fester Dimensionierung ist daher genau auf eine bestimmte Ausgangsleistung abgestimmt und nur für diese Ausgangsleistung optimal.

Zusätzlich bildet sich mit steigendem Pumpstrom auch im aktiven Volumen eine thermische Linse aus, die zu einer Veränderung der Grundmode in Form einer Einschnürung führt. Damit ändert sich die Feldverteilung im Resonator, so daß die Grundmode nicht mehr an die ursprüngliche Dimensionierung der Modenblende angepaßt ist. Als Folge dieser Fehlanpassung können unerwünschte höhere Moden anschwingen, wobei die Grundmode abgeschwächt oder sogar ausgelöscht wird.

Die Fehlanpassung kann dadurch kompensiert werden, daß das aktive Volumen und damit auch die Grundmode mit steigendem Pumpstrom transversal vergrößert und so einer Einschnürung entgegengewirkt wird.

Bei einem offenen Kontakt wie bei dem in Figur 2a, b gezeigten, V-förmigen Kontakt bildet sich bei geringem Pumpstrom 4 ein kleines aktives Volumen 14 im Inneren des Kontaktbereichs aus, das sich mit zunehmendem Pumpstrom 4 in Richtung der Kontaktöffnung vergrößert. In Figur 2b schematisch dargestellt ist das aktive Volumen 15 bei mittlerem Pumpstrom und das aktive Volumen 16 bei hohem Pumpstrom.

Damit bewirkt ein offener Kontakt ein selbstregulierendes Verhalten eines VCSEL, das einer Fehlanpassung zwischen Grundmode und aktivem Volumen entgegenwirkt.

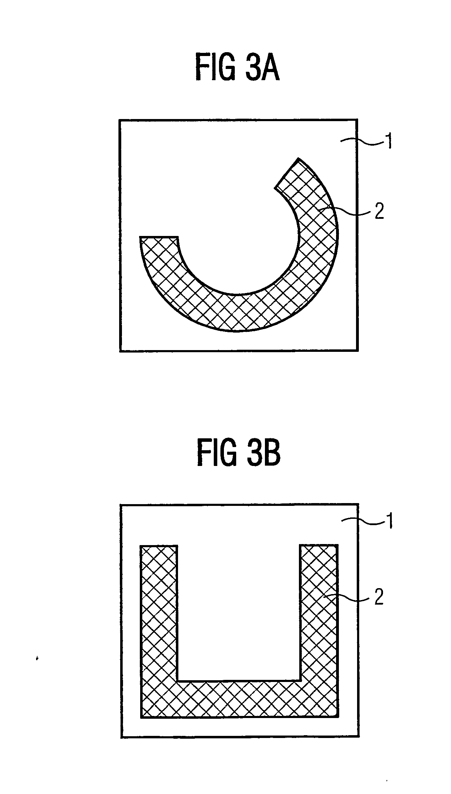

In Figur 3 sind weitere offene Kontaktformen dargestellt, die ebenfalls die oben beschriebene Aufweitung des aktiven Volumens mit steigendem Pumpstrom 4 bewirken.

So kann der Kontakt 2 in Form eines Kontaktrings ausgebildet sein, aus dem ein Ringsektor ausgeschnitten ist (Figur 3a). Ein weiteres Ausführungsbeispiel besteht darin, den Kontakt 2 wie in Figur 3b dargestellt U-förmig zu gestalten.

Mit Vorteil kann bei der Erfindung die Form der Kontaktfläche leicht durch Änderung der Maskierung der Auskoppelfläche bei der Herstellung der Kontaktfläche 2 variiert werden.

Selbstverständlich kann der Kontakt 2 auch vollständig ringförmig ausgebildet sein, wenn nur die oben beschriebene Vermeidung einer thermischen Linse im Resonatorvolumen ohne selbstregulierendes Verhalten beabsichtigt ist.

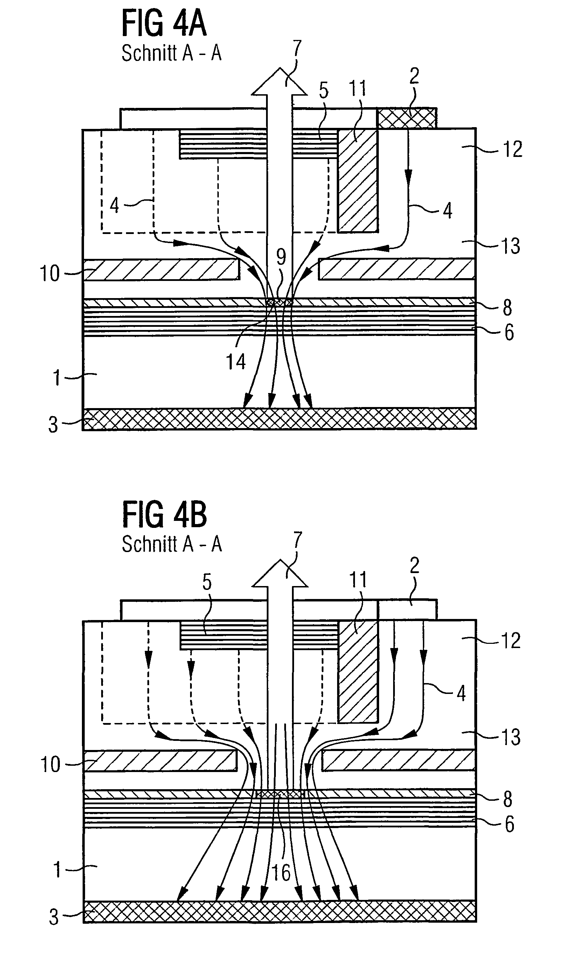

In Figur 4 ist in einer Schnittansicht die Wirkung der offenen Kontaktform für verschiedene Pumpströme dargestellt. Die Schnittebene ist hierbei so gewählt, daß die Resonatorachse in der Schnittebene liegt und die Schnittebene diagonal durch die in Figur 2b gezeigte Aufsicht verläuft (Linie A-A, Figur 2b).

Für geringe Pumpströme bildet sich ein kleines aktives Volumen 14 aus, Figur 4a. Entsprechend besitzt der VCSEL mit Vorteil eine sehr geringe Pumpschwelle. Mit steigendem Pumpstrom würde sich bei einem VCSEL nach dem Stand der Technik mit festem aktivem Volumen in der aktiven Schicht eine starke thermische Linse ausbilden, die Grundmode würde abschnüren und höhere Moden könnten anschwingen.

Bei der Erfindung hingegen dehnt sich das aktive Volumen 14 in radialer Richtung hin aus, Figur 4b. Das größere aktive Volumen 16 führt dazu, daß sich auch die Grundmode radial ausdehnt und wirkt einer Einschnürung entgegen. Weiterhin wird mit der Ausdehnung des aktiven Volumens auch die Verlustwärme besser verteilt und der radiale Temperaturgradient, der die Brechkraft der thermischen Linse maßgeblich bestimmt, vorteilhaft reduziert.

Die Erläuterung der Erfindung anhand der beschriebenen Ausführungsbeispiele ist selbstverständlich nicht als Beschränkung der Erfindung zu verstehen.

## Patentansprüche

1. VCSEL mit einem Halbleiterkörper (1), der ein Resonatorvolumen mit einer Resonatorachse, eine ein Strahlung (7) erzeugendes aktives Volumen (9) umfassende aktive Schicht (8) und eine erste und eine zweite Hauptfläche aufweist, wobei auf der ersten Hauptfläche eine erste Kontaktfläche (2) und auf der zweiten Hauptfläche eine zweite Kontaktfläche (3) gebildet ist und die erzeugte Strahlung (7) zumindest teilweise durch die erste Hauptfläche ausgekoppelt wird, **dadurch gekennzeichnet, daß** der Pumpstrom (4) in einem ersten Bereich (12) von der ersten Hauptfläche zur aktiven Schicht (8) hin außerhalb des Resonatorvolumens vorwiegend parallel zur Resonatorachse geführt wird und daß in einem zweiten Bereich (13) der Pumpstrom (4) vorwiegend senkrecht zur Resonatorachse zum aktiven Volumen (9) hingeführt wird, wobei zwischen dem ersten Bereich (12) und dem Resonatorvolumen eine Isolationsschicht (11) ausgebildet ist.

2. VCSEL nach Anspruch 1,
**dadurch gekennzeichnet, daß** zwischen dem zweiten Bereich (13) und der aktiven Schicht (8) eine Stromeinschnürungsschicht (10) ausgebildet ist.

3. VCSEL nach Anspruch 2,
**dadurch gekennzeichnet, daß** die Stromeinschnürungsschicht (10) eine Apertur aufweist, die entlang der Resonatorachse gesehen zumindest teilweise mit dem aktiven Volumen (9) überlappt.

4. VCSEL nach Anspruch 2 oder 3,
**dadurch gekennzeichnet, daß** die Stromeinschnürungsschicht (10) durch Ionenimplantation gebildet ist.

5. VCSEL nach Anspruch 2 oder 3,
**dadurch gekennzeichnet, daß** die Stromeinschnürungsschicht (10) eine ringförmige Oxidschicht ist.

6. VCSEL nach einem der Ansprüche 1 bis 5, **dadurch gekennzeichnet, daß** die Isolationsschicht (11) durch Ionenimplantation gebildet ist.

7. VCSEL nach einem der Ansprüche 1 bis 5, **dadurch gekennzeichnet, daß** die Isolationsschicht (11) vermittels eines Ätzgrabens gebildet ist.

8. VCSEL nach Anspruch 7,
**dadurch gekennzeichnet, daß** der Ätzgraben mit einem Isolations- oder Absorbermaterial gefüllt ist.

9. VCSEL nach einem der Ansprüche 1 bis 8, **dadurch gekennzeichnet, daß** die Kontaktfläche (2) ringförmig gebildet ist und die erzeugte Strahlung (7) durch die Ringöffnung austritt.

10. VCSEL nach einem der Ansprüche 1 bis 9, **dadurch gekennzeichnet, daß** die erste Kontaktfläche (2) ringförmig gebildet ist, wobei der Ring nicht geschlossen ist.

11. VCSEL nach einem der Ansprüche 1 bis 10, **dadurch gekennzeichnet, daß** die erste Kontaktfläche (2) U-förmig ausgebildet ist.

12. VCSEL nach einem der Ansprüche 1 bis 11, **dadurch gekennzeichnet, daß** die erste Kontaktfläche (2) V-förmig ausgebildet ist.

13. VCSEL nach einem der Ansprüche 1 bis 12,
**dadurch gekennzeichnet, daß** die Isolationsschicht (11) einen lateralen Querschnitt aufweist, der der Form der Kontaktfläche (2) entspricht.

14. VCSEL einem der Ansprüche 1 bis 13,
**dadurch gekennzeichnet, daß** die Kontaktfläche (2) derart geformt ist, daß mit steigendem Pumpstrom (4) die laterale Querschnittsfläche des aktiven Volumens (9) gleich bleibt oder anwächst.

## Claims

1. VCSEL comprising a semiconductor body (1), which has a resonator volume having a resonator axis, an active layer (8) comprising an active volume (9) that generates radiation (7), and a first and a second main area,
wherein a first contact area (2) is formed on the first main area and a second contact area (3) is formed on the second main area and the radiation (7) generated is coupled out at least in part through the first main area,
**characterized in that**
the pump current (4) is guided in a first region (12) from the first main area toward the active layer (8) outside the resonator volume predominantly parallel to the resonator axis, and **in that**, in a second region (13), the pump current (4) is guided toward the active volume (9) predominantly perpendicularly to the resonator axis, wherein an insulation layer (11) is formed between the first region (12) and the resonator volume.

2. VCSEL according to Claim 1,
**characterized in that**
a current constriction layer (10) is formed between the second region (13) and the active layer (8).

3. VCSEL according to Claim 2,
**characterized in that**
the current constriction layer (10) has an aperture which, as viewed along the resonator axis, at least partly overlaps the active volume (9).

4. VCSEL according to Claim 2 or 3,
**characterized in that**
the current constriction layer (10) is formed by ion implantation.

5. VCSEL according to Claim 2 or 3,
**characterized in that**
the current construction layer (10) is a ring-shaped oxide layer.

6. VCSEL according to any of Claims 1 to 5, **characterized in that**
the insulation layer (11) is formed by ion implantation.

7. VCSEL according to any of Claims 1 to 5, **characterized in that**
the insulation layer (11) is formed by means of an etching trench.

8. VCSEL according to Claim 7,
**characterized in that**
the etching trench is filled with an insulation or absorber material.

9. VCSEL according to any of Claims 1 to 8, **characterized in that**
the contact area (2) is formed in ring-shaped fashion and the radiation (7) generated exits through the ring opening.

10. VCSEL according to any of Claims 1 to 9, **characterized in that**
the first contact area (2) is formed in ring-shaped fashion, wherein the ring is not closed.

11. VCSEL according to any of Claims 1 to 10, **characterized in that**
the first contact area (2) is formed in U-shaped fashion.

12. VCSEL according to any of Claims 1 to 11, **characterized in that**
the first contact area (2) is formed in V-shaped fashion.

13. VCSEL according to any of Claims 1 to 12, **characterized in that**
the insulation layer (11) has a lateral cross section corresponding to the form of the contact area (2).

14. VCSEL according to any of Claims 1 to 13, **characterized in that**
the contact area (2) is shaped in such a way that, as the pump current (4) rises, the lateral cross-sectional area of the active volume (9) remains the same or increases.

## Revendications

1. VCSEL comprenant un corps semiconducteur (1) qui présente un volume résonateur avec un axe de résonateur, un volume actif (9) produisant un rayonnement (7) comprenant une couche active (8) et une première ainsi qu'une deuxième surface principale, une première surface de contact (2) étant formée sur la première surface principale et une deuxième surface de contact (3) sur la deuxième surface principale et le rayonnement (7) généré étant découplé au moins partiellement à travers la première surface principale, **caractérisé en ce que** le courant de pompage (4) est conduit dans une première zone (12) de la première surface principale en direction de la couche active (8) à l'extérieur du volume résonateur pour l'essentiel parallèlement à l'axe de résonateur et que, dans une deuxième zone (13), le courant de pompage (4) est introduit vers le volume actif (9) pour l'essentiel perpendiculairement à l'axe de résonateur, une couche d'isolation (11) étant formée entre la première zone (12) et le volume résonateur.

2. VCSEL selon la revendication 1, **caractérisé en ce qu'**une couche de restriction du courant (10) est formée entre la deuxième zone (13) et la couche active (8) .

3. VCSEL selon la revendication 2, **caractérisé en ce que** la couche de restriction du courant (10) présente une ouverture qui, vue le long de l'axe de résonateur, chevauche au moins partiellement le volume actif (9).

4. VCSEL selon la revendication 2 ou 3, **caractérisé en ce que** la couche de restriction du courant (10) est formée par implantation d'ions.

5. VCSEL selon la revendication 2 ou 3, **caractérisé en ce que** la couche de restriction du courant (10) est une couche d'oxyde en forme d'anneau.

6. VCSEL selon l'une des revendications 1 à 5, **caractérisé en ce que** la couche d'isolation (11) est formée par implantation d'ions.

7. VCSEL selon l'une des revendications 1 à 5, **caractérisé en ce que** la couche d'isolation (11) est formée au moyen d'une fosse de corrosion.

8. VCSEL selon la revendication 7, **caractérisé en ce que** la fosse de corrosion est remplie de matériau d'isolation ou d'absorption.

9. VCSEL selon l'une des revendications 1 à 8, **caractérisé en ce que** la surface de contact (2) est réalisée en forme d'anneau et le rayonnement (7) produit sort à travers l'ouverture annulaire.

10. VCSEL selon l'une des revendications 1 à 9, **caractérisé en ce que** la première surface de contact (2) est réalisée en forme d'anneau, l'anneau n'étant pas fermé.

11. VCSEL selon l'une des revendications 1 à 10, **caractérisé en ce que** la première surface de contact (2) est réalisée en forme de U.

12. VCSEL selon l'une des revendications 1 à 11, **caractérisé en ce que** la première surface de contact (2) est réalisée en forme de V.

13. VCSEL selon l'une des revendications 1 à 12, **caractérisé en ce que** la couche d'isolation (11) présente une section transversale latérale qui correspond à la forme de la surface de contact (2).

14. VCSEL selon l'une des revendications 1 à 13, **caractérisé en ce que** la surface de contact (2) est formée de telle sorte que la section transversale latérale du volume actif (9) reste égale ou augmente à mesure que le courant de pompage (4) croît.
